(19) Europäisches Patentamt

European Patent Office

Office européen des brevets

(11) **EP 1 251 357 B1**

(12) **EUROPÄISCHE PATENTSCHRIFT**

(45) Veröffentlichungstag und Bekanntmachung des Hinweises auf die Patenterteilung:
**10.09.2003   Patentblatt 2003/37**

(51) Int Cl.⁷: **G01R 27/02**

(21) Anmeldenummer: **02008351.5**

(22) Anmeldetag: **12.04.2002**

(54) **Widerstandsmessung**

Resistance measurement

Mesure de résistance

(84) Benannte Vertragsstaaten:
**DE FR GB IT**

(30) Priorität: **19.04.2001  DE 10119080**

(43) Veröffentlichungstag der Anmeldung:
**23.10.2002   Patentblatt 2002/43**

(73) Patentinhaber: **Acam-messelectronic GmbH**
**76297 Stutensee-Blankenloch (DE)**

(72) Erfinder: **Braun, Augustin**
**76689 Karlsdorf-Neuthard (DE)**

(74) Vertreter: **Lempert, Jost, Dipl.-Phys. Dr. rer.nat.**
**Patentanwälte,**
**Dipl.-Ing. Heiner Lichti,**
**Dipl.-Phys. Dr. rer. nat. Jost Lempert,**
**Dipl.-Ing. Hartmut Lasch,**
**Postfach 41 07 60**
**76207 Karlsruhe (DE)**

(56) Entgegenhaltungen:
- **PATENT ABSTRACTS OF JAPAN vol. 2000, no. 05, 14. September 2000 (2000-09-14) & JP 2000 055954 A (GLORY LTD), 25. Februar 2000 (2000-02-25)**
- **PATENT ABSTRACTS OF JAPAN vol. 013, no. 343 (E-796), 2. August 1989 (1989-08-02) & JP 01 100870 A (YUASA BATTERY CO LTD), 19. April 1989 (1989-04-19)**
- **PATENT ABSTRACTS OF JAPAN vol. 1998, no. 10, 31. August 1998 (1998-08-31) & JP 10 135412 A (OKI ELECTRIC IND CO LTD), 22. Mai 1998 (1998-05-22)**
- **PATENT ABSTRACTS OF JAPAN vol. 017, no. 643 (P-1651), 29. November 1993 (1993-11-29) & JP 05 209852 A (YOKOGAWA ELECTRIC CORP), 20. August 1993 (1993-08-20)**

**Beschreibung**

Die Erfindung betrifft ein Verfahren zur Widerstandsmessung und eine zur Durchführung des Verfahrens geeignete Schaltungsanordnung.

Derartige Verfahren und Schaltungen können beispielsweise zur Bestimmung von Widerstandswerten von Dehnungsmessstreifen (DMS) und damit zur Messung von Dehnungen, beispielsweise zur Bestimmung von Kräften, Drücken oder Drehmomenten, oder auch zur Erzeugung temperaturabhängiger Signale eingesetzt werden.

Insbesondere zur Temperaturmessung ist bekannt, einen temperaturabhängigen Widerstand mit einem genau bekannten Konstantstrom zu speisen und den sich ergebenden Spannungsabfall am Widerstand mittels eines genauen Analog-Digital-Wandlers zu digitalisieren. Hierzu werden hochqualitative und damit sehr teure analoge Komponenten benötigt, deren Kennlinie sich über einen weiten Temperaturbereich nicht nennenswert verschieben darf.

Weiterhin ist es bekannt, in einem ersten Schritt mit Hilfe eines Referenzwiderstandes einen Strom einer Konstantstromquelle einzustellen, durch diese an einem Kondensator eine Spannung bis zu einem gewissen bestimmten Wert zu integrieren und die Zeit, bis der genannte Spannungswert erreicht wird, mit einem Zähler zu messen sowie den Zählerstand zu speichern. In einem zweiten Schritt wird der Konstantstrom mit einem temperaturabhängigen Messwiderstand eingestellt und invertiert und mit diesem Strom der Kondensator entladen. Es wird wieder die Zeit bis zur vollständigen Entladung des Kondensators gemessen und der entsprechende Zählerstand festgehalten. Das Verhältnis der beiden Zählerstände ist das Verhältnis der beiden Widerstände, welche die gemessene Temperatur wiedergibt. Auch hierzu sind sehr präzise und damit teure Anlagenkomponenten erforderlich, da ansonsten Fehlereinflüsse sehr schnell untragbar werden.

Aus der DE 36 42 861 C2 ist weiterhin eine Schaltungsanordnung zur Erzeugung eines temperaturabhängigen Signals bekannt, wobei ein Referenzwiderstand und ein temperaturabhängiger Widerstand vorgesehen sind, mittels derer eine Referenzzeit und eine Messzeit erzeugbar sind und aus dem Vergleich dieser Zeiten ein der Messtemperatur zugeordnetes Digitalsignal ableitbar ist. Hierzu wird ein Ladekondensator wechselweise über den Referenzwiderstand und den temperaturabhängigen Widerstand auf gleiche, vorbestimmte Schwellspannungen aufgeladen, die Ladezeiten werden gemessen, womit bei bekanntem Referenzwiderstand aus dem Verhältnis der Wert des temperaturabhängigen Messwiderstandes und damit ein Temperaturwert bestimmbar ist.

Der Vorteil dieser Schaltung und des entsprechenden Verfahrens gegenüber den vorgenannten liegt darin, dass keine analogen Komponenten benötigt und an die Qualität der (digitalen) Komponenten keine besonderen Ansprüche gestellt werden. Nachteilig ist aber zunächst, dass die Messung während des Ladevorgangs erfolgt, aber ein relativ hoher Strom fließen muss, der bei vielen möglichen Einsatzzwecken von einer Batterie bzw. einem Solarmodul geliefert werden muss. Darüber hinaus bedingt der Innenwiderstand der Batterie bzw. des Moduls einen Störeinfluss hinsichtlich der Widerstandsbestimmung des Referenz- und Messwiderstandes.

Ein weiterer wesentlicher Nachteil liegt darin, dass mittels der Bestimmung der Ladezeit nicht der Widerstandswert des Referenz- bzw. Messwiderstands alleine, sondern der Widerstandswert gemessen wird, der durch jeweils den genannten Widerstand und den Innenwiderstand des in Reihe mit diesem geschalteten elektronischen Schalter, einem Transistor, gegeben ist, der letztere unbekannt ist. Solange der Widerstandswert des Schalters, bei CMOS-Transistoren mit 10 bis 20 Ω, gegenüber den Widerstandswerten des Referenz- und des Messwiderstandes, bei NTC-Widerständen im Bereich von 15 bis 20 kΩ, vernachlässigbar ist, arbeiten das bekannte Verfahren und die bekannte Schaltung zufriedenstellend. Für hochgenaue Temperaturmessungen können aber derartige NTC-Widerstände wegen ihrer Nicht-Linearität und fehlenden Langzeitstabilität nicht eingesetzt werden. Hier müssen Platinwiderstände eingesetzt werden, die wesentlich geringere Widerstandswerte in der Größenordnung von 100 bis 500 Ω haben. Damit ergibt sich mit den vorgenannten Schalter-Widerstandswerten aufgrund derselben ein erheblicher Fehler, insbesondere wenn man berücksichtigt, dass ein Platinwiderstand bei einer Temperaturänderung von 1°C seinen Widerstandswert nur um 0,4% verändert. Auch der Einsatz von teuren externen Power-MOSFETS kann die angesprochene Problematik nicht lösen. Diese weisen zwar den Widerstandswert von ca. 10 bis 15 mΩ auf, bei einem Platinwiderstand PT100 führt aber eine Temperaturänderung von 0,01°C zu einer Widerstandsänderung von 4 mΩ und damit in der Größenordnung des Widerstandes des genannten MOSFETS-Schalters. Darüber hinaus sind derartige Power-MOSFETS nicht nur teuer, sondern aus weiteren Gründen für die Messelektronik ungeeignet.

Ein wesentlicher Nachteil von Dehnungsmessstreifen (DMS) ist der geringe Hub der Widerstandsänderung von DMS. Typischerweise ändert sich der Widerstand einer DMS-Anordnung von 0 bis Vollausschlag um ca. 0,2%. Dieser Wert wird üblicherweise als Änderung in ppm (parts per million) ausgedrückt. Dabei entspricht 0,2% dem Wert von 2000 ppm. Ein DMS hat also typischerweise einen Hub von 2000 ppm. Dagegen ändert ein typischer temperaturabhängiger Widerstand aus Platin (z.B. PT500) seinen Widerstand pro Grad Temperaturunterschied um 3920 ppm oder bei einem typischen Temperaturhub von 100°C um 392000 ppm oder 39,2%. Deshalb lassen sich Verfahren, die aus der Temperaturmessung bekannt sind, nicht ohne weiteres auf DMS übertragen, da der Hub von DMS etwa 200 mal geringer ist. Zudem spielen bei derart kleinen Messgrößen zunehmend die unumgänglichen Rauscheinwirkungen der verwendeten elektronischen Bauteile bzw. Schaltungen eine entscheidende Rolle, was die Messgenauigkeit und das Auflösungsvermögen eines Verfahrens bzw. einer Schaltungsanordnung zum Messen derartiger Größen zusätzlich beeinträchtigt.

Bei Zeit- oder zeitaufgelösten Messverfahren, die zur Vermeidung von Einflüssen unterschiedlichen Kurvenformen der Messsignale einen Schwellwertschalter, z.B. einen Schmitt-Trigger, verwenden, ergibt sich aufgrund der Verzögerung des Schwellwertschalters ein weiteres Problem, da diese Verzögerung in der Regel nicht vernachlässigbar ist. Sie macht sich speziell bei DMS im Messergebnis in der Praxis mit Werten bis zu 10 ppm bemerkbar. Da sie auch noch stark von der Temperatur und Spannung abhängig ist, macht sich die Verzögerung des Schwellwertschalters zusätzlich noch als Temperaturfehler bemerkbar.

Vorbekannte Verfahren zur elektrischen Widerstandsmessung, wie z.B. aus der DE 44 20 998 C2 bekannt, verwenden zur Bestimmung von Zeitintervallen Signalverarbeitungsmittel in Form von Prozessoren oder schnellen Zählern.

Im Prozessorbereich lasen sich momentan bei üblichen Prozessen maximale Taktfrequenzen von ca. 20 MHz realisieren. Bei Verwendung schneller Zähler auf Hardwarebasis ließen sich diese auf ca. 200 MHz steigern. Über diesen Wert hinaus verhindern deutlich erhöhte Kosten und große Stromaufnahme bzw. Verlustleistung die Konkurrenzfähigkeit einer derartigen Vorrichtung, die daher wegen ihrer begrenzten Zeitauflösung nur begrenzt einsetzbar sind.

Der Erfindung liegt daher die Aufgabe zugrunde, ein Verfahren und eine Schaltung zur genauen Messung von Widerständen unter Vermeidung der vorgenannten Nachteile zu schaffen.

Erfindungsgemäß wird die genannte Aufgabe mit Verfahren nach den Ansprüchen 1 und 2 gelöst.

Erfindungsgemäß wird also der gleiche Nutzwiderstand in unterschiedlicher Kombination mit den auswechselbaren parasitären Schalterwiderständen gemessen, so dass der Störanteil der Schalterwiderstände eliminiert werden kann. Die erfinderische Schaltung sieht dabei vor, dass mit dem jeweiligen Widerstand, Referenz- und Messwiderständen, nicht nur ein Schalter, sondern ein weiterer Schalter in Reihe geschaltet ist (wobei die Schalter zueinander parallel geschaltet sind). Dies ermöglicht beim erfindungsgemäßen Verfahren, Entlademessungen nicht nur bei der Entladung eines Widerstands über einen Schalter, sondern auch bei der Entladung über den anderen Schalter und bei der Entladung bei gleichzeitig durchgeschalteten beiden Schaltern vorzunehmen und aufgrund der gemessenen unterschiedlichen Ladezeiten die Innenwiderstände der Schalter und damit deren Einfluss auf das Messergebnis vollständig zu eliminieren, so dass die Innenwiderstände der Schalter keinerlei Rolle bei der Bestimmung des Messergebnisses mehr spielen und dieses nicht verfälschen können.

In bevorzugter Weise ist vorgesehen, dass die Zeitmessung nicht beim Laden, sondern beim Entladen vorgenommen wird. Hierdurch wird es möglich, den Ladevorgang auch mit einem geringen Strom durchzuführen, so dass schwächere Stromquellen gesetzt werden können.

Ein wesentlicher Vorteil der Erfindung liegt darin, dass keine teuren und aufwendigen externen Transistoren eingesetzt werden müssen, sondern in den Prozessoren sowie sonstigen integrierten Schaltungen, wie FPGAs oder ASICs verfügbaren Transistoren eingesetzt werden können, so dass die gesamte Schaltung vollständig als integrierte Schaltung ausgebildet werden kann und demgemäß, wie gesagt, keine externen Transistoren notwendig sind.

Bei Platinwiderständen mit 500 Ω Widerstandswert (PT500) reichen bereits Standardtransistoren, sogenannte 8mA-Typen aus, wie bei 100 Ω-Platinwiderständen mindestens 24mA-Standardtransistoren eingesetzt werden sollten, die allerdings auch wiederum durch Parallelschalten von mehreren 8mA-Transistoren realisiert werden können.

Die Erfindung beinhaltet einen vollständig anderen Ansatz als der Stand der Technik, der Störeffekte nicht lediglich minimiert, sondern durch die erfindungsgemäß vorgesehene Schaltung und das erfindungsgemäße Messverfahren vollständig eliminiert. Die Bestimmung der heranzuziehenden Widerstandswerte von Referenz- und Messwiderständen unter Ausschaltung der inneren Widerstände der Schalter kann durch ohnehin bei üblichen Einsatzzwecken vorhandene Prozessoren oder spezielle Rechenschaltungen in integrierten Schaltungen (ASICs oder FPGAs) schnell und stromsparend durchgeführt werden. Die erfindungsgemäße Widerstandsmessung ist preisgünstig zu realisieren und erfordert keine analogen Komponenten; sie ist extrem spannungs- und temperaturstabil. Als Zähler können sogenannte Zeit-Digital-Wandler (Time-to-Digital-Converter, TDC) eingesetzt werden, deren Stromaufnahme gegenüber Stromaufnahmen bisheriger Lösungen um mehr als eine Zehner-Potenz gesenkt werden kann.

Während bei dem oben genannten erfindungsgemäßen Verfahren zur Bestimmung des Widerstandes die Kapazität des Kondensators noch bekannt sein muss, sieht die Erfindung in einer bevorzugten Ausgestaltung vor, dass die oben aufgeführten Messungen und Bestimmungen wiederholt über zwei oder mehrere Widerstände durchgeführt und zur Bestimmung des Widerstandsverhältnisses von zwei Widerständen die Ergebnisse jeweils durcheinander dividiert werden.

Um speziell im Rahmen einer Anwendung des erfindungsgemäßen Verfahrens mit Dehnungsmessstreifen (DMS) eine hohe Messgenauigkeit zu erzielen, sieht eine Weiterbildung des erfindungsgemäßen Verfahrens vor, dass die Bestimmung des Widerstands $R_i$ (i=1,2,3) mittels der Beziehung

$$C \cdot Ri = ti - \sqrt{ti^2 + ti1 \cdot ti2 - ti1 \cdot ti - ti2 \cdot ti}$$

$$= M + K$$

erfolgt, die einen Messterm (M) und einen Korrekturterm (K) enthält. Der Korrekturterm repräsentiert den Zeitanteil aus den Innenwiderständen der Schalttransistoren. Dieser Korrekturterm ändert sich nicht mit dem zu messenden Wert, speziell der Dehnung des DMS, sondern nur mit der Änderung der Innenwiderstände, d.h. bei Temperatur- oder Spannungsschwankungen. Da es sich hierbei nur um langsame Änderungen handelt, ist es möglich, den Korrekturterm sehr hoch zu mitteln und damit weitgehend von Rauscheffekten zu befreien. Demgemäß sieht eine bevorzugte Weiterbildung des erfindungsgemäßen Verfahrens vor, dass der Korrekturterm und der Messterm mit unterschiedlichen Mittelungsarten gemittelt werden und darüber hinaus, dass der Korrekturterm um einen bestimmten Faktor, insbesondere um einen Faktor zwischen 32 und 64, höher gemittelt wird als der Messterm.

Auf diese Weise wird das Rauschen des Korrekturterms im Verhältnis zum Messterm beinahe auf Null reduziert. Die niedrigere Mittelung des Messterms sorgt dafür, dass auch kurzperiodische Änderungen des Messwertes, z.B. bei Schwingungsmessungen, nicht verloren gehen.

Um die an sich problematische Verzögerung des Schwellwertschalters (Schmitt-Trigger) aus den Messergebnissen zu eliminieren, sieht das erfindungsgemäße Verfahren vor, dass die gemessenen Zeiten um eine Verzögerungszeit des Schwellwertschalters reduziert werden. Dazu wird die Verzögerungszeit durch Messen der Zeit jeweils einer Kondensatoraufladung bzw. einer Kondensatorentladung über einen ersten Widerstand und einen zweiten Widerstand sowie eine Parallelschaltung dieser beiden Widerstände durch Schließen eines ersten Schalters, eines zweiten Schalters bzw. dieser beiden Schalter bestimmt.

Die Verzögerung des Schmitt-Triggers teilt sich in zwei Zeitanteile auf: Ein Zeitanteil ist von den Grundparametern des Schmitt-Triggers an sich sowie von Temperatur- und Spannungseinflüssen anhängig. Der zweite, betragsmäßig kleinere Zeitanteil hängt von der Steilheit der Eingangsflanke des Signals am Schmitt-Trigger ab. Im vorliegenden Fall ist dies eine e-Funktion, die durch die Lade- bzw. Entladecharakteristik des Kondensators bedingt ist. Der erste, dominante dieser beiden Zeitanteile erlässt sich durch das erfindungsgemäße Verfahren kompensieren, wodurch der durch die Verzögerung des Schwellwertschalters hervorgerufene Messfehler deutlich reduzierbar ist.

Nach einer äußerst bevorzugten Weiterentwicklung des erfindungsgemäßen Verfahrens ist vorgesehen, dass die Auf- bzw. Entladezeiten zur Widerstandsmessung und die Verzögerungszeit separat bestimmt werden. Dabei wird zur Zeitmessung vorzugsweise ein Zeit-Digital-Wandler (TDC) verwendet.

Bei Verwendung einer Zeitmesseinrichtung in Form eines TDC lassen sich im Vergleich mit üblicherweise eingesetzten Prozessoren oder Hardware-Zählern deutlich höhere Taktfrequenzen von > 50 GHz erreichen. Damit arbeitet das erfindungsgemäße Verfahren ca. 250 mal schneller als schnelle Zählervarianten und zeichnet sich darüber hinaus durch eine deutlich geringere Stromaufnahme aus. Im Rahmen von Anwendungen, bei denen sich unter Verwendung eines TDC eine Messwertauflösung von 11 Bit, d.h. eine mehr als 2000-fache Unterteilung des Messbereiches bei einer Messfrequenz von 100 Hz realisieren lassen, liefern Zählervarianten nur einen Messwert pro 2,5 Sekunden und sind somit nicht konkurrenzfähig. Zur Vermeidung derartiger Nachteile müssten im Zuge der vorbekannten Verfahren Kondensatoren mit 250-facher Kapazität eingesetzt werden. Solche Kondensatoren lägen im Bereich einiger µF, würden jedoch nicht die hohen Anforderungen an die Linearität erfüllen, im Zuge derartiger Anwendungen erforderlich ist. Derartige Anforderungen werden nur von Kondensatoren mit speziellen Dielektrika erfüllt (z.B. Kunststoffe), mit denen sich jedoch derartige hohe Kapazitäten nicht vernünftig realisieren lassen.

In Weiterbildung der erfindungsgemäßen Schaltung ist vorgesehen, dass mindestens einer der Widerstände ein bekannter Referenzwiderstand und mindestens ein Widerstand ein unbekannter Messwiderstand ist.

Ein bevorzugtes Einsatzgebiet der Erfindung ist die Messung mechanischer Größen mittels Dehnungsmessstreifen (DMS), die durch Dehnung ihren Widerstand verändern. Auch bei Dehnungsmessstreifen kommt es sehr stark auf die Anwendung an, wie viele Widerstände gemessen werden. Es wird hier oft eine gesamte Brücke aus vier Widerständen gemessen, da erst durch die mechanische Anordnung der DMS-Widerstände auf dem zu messenden Objekt (z.B. der Wägezelle einer Waage) die geforderte Genauigkeit und Linearität erreicht wird. Hier sind mitunter z. B. bei einer Vollbrücke, alle Widerstände Messwiderstände und nur das Verhältnis der Widerstände untereinander ergibt den Messwert.

Ein anderes Einsatzgebiet ist die Wärmeverbrauchsbestimmung eines Wärmeverbrauchers. Bei einer hier erforderlichen Temperaturmessung ist typischerweise einer der Widerstände, beispielsweise R1, ein bekannter Referenzwiderstand, während mittels der weiteren Mess-Widerstände jeweils die Temperatur im Vor- und - temperaturabhängigen - Rücklauf einer Heizung gemessen und aus der Differenz dieser beiden Temperaturen - repräsentiert durch die Widerstandswerte der Messwiderstände - die verbrauchte Wärmemenge berechnet wird.

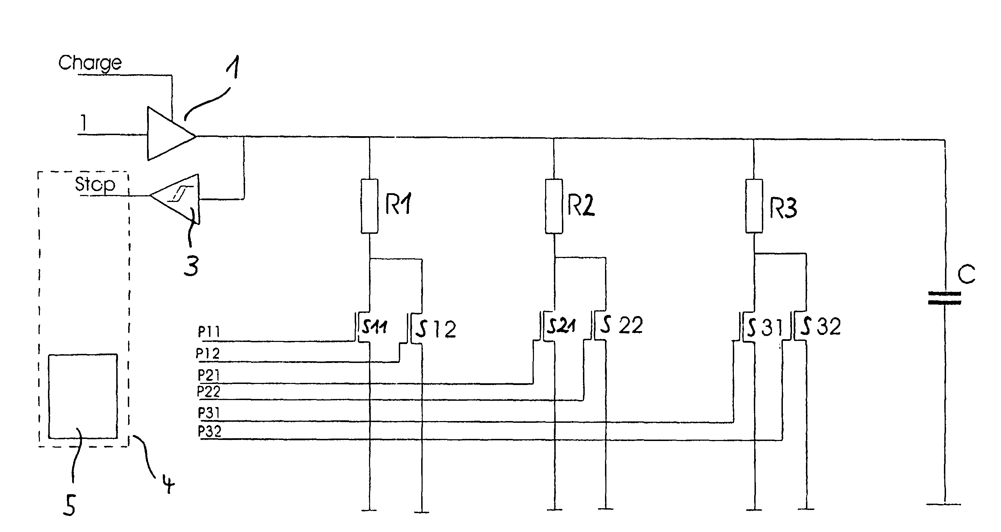

Weitere Vorteile und Merkmale der Erfindung ergeben sich aus den Ansprüchen und aus der nachfolgenden Beschreibung, in der ein Ausführungsbeispiel der Erfindung unter Bezugnahme auf die Zeichnung im einzelnen erläutert ist. Dabei zeigt die einzige Figur:

eine bevorzugte Ausgestaltung der erfindungsgemäßen Schaltung.

Die Schaltung weist eine Stromquelle 1 in Form eines Tri-State-Buffers auf, über die ein Kondensator C aufladbar ist. Beim dargestellten Ausführungsbeispiel sind dem Kondensator parallel und zueinander parallel drei Widerstände R1, R2 und R3 geschaltet. Diesen sind wiederum in Reihe und zueinander parallel jeweils zwei Schalter S11 und S12 - zu R1 - bzw. S21 und S22 - zu R2 - bzw. S31 und S32 - zu R3 - zugeordnet.

Es ist weiterhin ein Schwellwertschalter 3, vorzugsweise ein Schmitt-Trigger vorgesehen, mittels dessen das Umschalten der einzelnen Schalter bei Erreichen des vorgesehenen Lade- bzw. Entladezustands des Kondensators C erfolgt. Die Schalter S11, S12, S21, S22, S31, S32 sind vorzugsweise CMOS-Transistoren, deren innerer Widerstand im ein- bzw. durchgeschalteten Zustand in sehr guter Näherung ein ohmscher Widerstand ist. Weiterhin weist die erfindungsgemäße Schaltung Signalverarbeitungsmittel 4 auf, die unter anderem eine Zeitmesseinrichtung 5 beinhalten. Die Signalverarbeitungsmittel 4 umfassen darüber hinaus insbesondere Mittel zur Bildung eines arithmetischen Mittels aus einer Anzahl von Messwerten.

Die Entladezeiten des Kondensators werden über den Schwellwertschalter 3 und die Zeitmesseinrichtung 5 gemessen, die beispielsweise aus TDCs (Time-to-Digital-Converter) gebildet sein kann, wie sie beispielsweise in der EP 508 232 B1 beschrieben sind (hier nicht detailliert dargestellt).

Ein Verfahren zur Widerstandsbestimmung unter Verwendung der vorstehend beschriebenen Schaltung gestaltet sich folgendermaßen:

Über die Stromquelle 1 wird der Kondensator C bei offenen Schaltern S11, S12, S21, S22, S31, S32 zunächst bis auf die Betriebsspannung aufgeladen. Sodann erfolgt das Entladen des Kondensators C jeweils durch Schließen des Schalters S11, Schließen des Schalters S12, Schließen beider Schalter S11 und S12 gleichzeitig, Schließen des Schalters S21, Schließen des Schalters S22 und Schließen des Schalters S21 und Schließen der Schalter S21 und S22 gleichzeitig usw., jeweils über die den entsprechenden Schaltern zugeordneten Widerstände R1, R2 bzw. R3, jeweils bis die Kondensatorspannung die Schwelle des Schwellwertschalters 3 unterschreitet, wobei die Zeiten des Entladens gemessen werden mit t11, t12 und t1, t21, t22 und t2 bzw. t31, t32 und t3. Bezeichnet man den inneren Widerstand der Schalter S11, S12, S21, S22, S31, S32 im eingeschalteten Zustand mit R11, R12, R21, R22, R31, R32, so lässt sich unter Elimination dieser Widerstände der Schalter die Zeitkonstante beispielsweise für den Entladevorgang des Kondensators über den Widerstand R1 mit Entladezeiten t11, t12, t1 wie folgt bestimmen:

$$(R11 + R1) \cdot C = t11 \; ,$$

$$(R12 + R1) \cdot C = t12,$$

$$\left( \frac{R11 \cdot R12}{R11 + R12} + R1 \right) \cdot C = t1 \; . \qquad (1)$$

Löst man dieses Gleichungssystem 1 mit drei Unbekannten nach R1 auf, indem man z.B. die vorstehenden ersten beiden Gleichungen jeweils nach R11 bzw. R12 auflöst, in die letzte Gleichung einsetzt und diese dann nach R auflöst, bekommt man eine quadratische Gleichung folgender Form:

$$R1^2 - \frac{2 \cdot t1}{C} R1 + \frac{t1 \cdot t11 + t1 \cdot t12 - t11 \cdot t12}{C^2} = O. \qquad (2)$$

Löst man diese Gleichung mit Hilfe der Standard-Formeln für quadratische Gleichungen auf, erhält man

$$C \cdot R1 = t1 - \sqrt{t1^2 + t11 \cdot t12 - t11 \cdot t1 - t12 \cdot t1} \qquad (3)$$

bzw. für die Entladung über den Widerstand R2

$$C \cdot R2 = t2 - \sqrt{t2^2 + t21 \cdot t22 - t21 \cdot t2 - t22 \cdot t2} \ , \qquad (4)$$

wobei die dargestellte "Minus"-Lösung die richtige Lösung ist, da von den beiden Lösungen die "Plus"-Lösung immer falsch ist (sie ergäbe einen zu großen Widerstand).

Eine Division der Gleichungen 3 und 4 führt auf eine Lösung, die vom Betrag der eingesetzten Kapazität unabhängig ist. Man erhält so das reine Widerstandsverhältnis der Widerstände.

Entsprechendes gilt für die Widerstandskombinationen R2 mit R21 und R22 sowie R3 mit R31 und R32 oder allgemein bei weiteren Widerstands-Schalter-Kombinationen.

Die Gleichungen 3 und 4 zeigen die Endformeln, nach denen Zähler und Nenner des Widerstandsverhältnisses bestimmt werden. Bei direkter Anwendung dieser Formeln ließe sich das Verhältnis der Widerstände mit einer Standardabweichung von ca. 25 ppm bestimmen. Genauere Messungen vereitelt zum einen das Rauschen des Komparators (Schmitt-Trigger; ca. 12-14 ppm), zum anderen das zusätzliche Rauschen, das durch den Korrekturterm (Wurzel) der Gleichungen 3 und 4 entsteht.

Ein Ausmessen eines DMS mit dieser Genauigkeit von 25 ppm ergäbe eine effektive Genauigkeit von ca. 80 Skalenteilen oder 6,3 Bit ($2^{6,3} \approx 80$). Mit dieser geringen Genauigkeit lassen sich praktisch keine Applikationen im DMS-Bereich bedienen. Die meisten Applikationen verlangen Genauigkeiten von 10-14 Bit, entsprechend 1024 bis 16384 Skalenteile.

Essentiell für ein erfolgreiches Ausmessen von DMS ist deshalb die erfindungsgemäße Mehrfachmessung und Mittelung der Ergebnisse, wozu die Erfindung ein doppeltes Mitteilungsverfahren vorschlägt.

Die Gleichungen 3 und 4 bestehen aus 2 Termen. Dabei ist die Wurzel der Korrekturterm, welcher den Zeitanteil aus den Innenwiderständen der Schalttransistoren repräsentiert. Da sich dieser Term nur langsam ändert, lässt er sich durch hohe Mittelung über größere Zeitintervalle weitgehend von seinem Rauschen entfernen.

Der erste Term beinhaltet den eigentlichen Messwert. Dieser kann nicht so hoch gemittelt werden, da ansonsten zu erfassende Änderungen des Messwertes verloren gehen. In der Praxis hat sich bewährt, den Korrekturterm ca. 32-64 mal höher zu mitteln als den Messterm. Dadurch reduziert sich das Rauschen des Korrekturterms im Verhältnis zum Messterm stark, so dass nur noch das Messterm-Rauschen relevant ist.

Mit dieser ersten Mittelung reduziert sich das Rauschen des Messwertes bei einer Einzelmessung auf ca. 12-14 ppm, d.h. auf das Komparatorrauschen. Ein solcher Wert ist für die meisten Anwendungen noch nicht ausreichend, weshalb auf eine zusätzliche Mittelung dieses in einem Term bereits vorgemittelten Wertes in der Regel nicht verzichtet werden kann. Sind beispielsweise 11 effektive Bit, d.h. 2048 Teile gefordert, so wird eine Genauigkeit von ca. 1 ppm benötigt. Das ist eine Verbesserung um einen Faktor 14 gegenüber der Einzelmessung. Um diese Genauigkeit zu erreichen, muss über eine Anzahl von Messwerten gemittelt werden, die dem Quadrat des Verbesserungsfaktors entspricht ($14 * 14 = 196$). Man macht daher ca. 200 Messungen und bildet den Mittelwert, wobei zuvor für jede dieser Messungen die oben beschriebene Mittelung des Korrekturterms vorzunehmen ist. Der Mittelwert hat jetzt eine Standardabweichung von ca. 1 ppm eff.

In der Praxis arbeitet man je nach benötigter Auflösung mit Mittelungsraten zwischen 50 und 10000.

Das Vorstehende verdeutlicht den Vorteil des erfindungsgemäßen Verfahrens im Vergleich zu üblichen Verfahren der Widerstandsmessung, speziell der DMS-Messung: Die Mittelungsrate lässt sich beliebig wählen und auch während des Betriebes problemlos ändern. Damit ist ein solches Gerät sehr universell auf die Messaufgabe einstellbar. Man kann in sehr weiten Bereichen zwischen einer schnellen weniger genauen Messung oder einer langsamen genaueren Messung wählen. In Laborversuchen ließen sich mit hohen Mittelungsraten Auflösungen der Messbereiche bis ca. 15 Bit erreichen. Damit sind wenigstens 95% aller Applikationen realisierbar.

Um die Verzögerung des Schwellwertschalters 3, beispielsweise eines Schmitt-Triggers, weitgehend zu eliminieren, wird nach erfolgter Aufladung des Kondensators C dieser zunächst über den Widerstand R1 durch Schließen des Schalters S11 entladen, wobei mittels des Schmitt-Triggers 3 und der Zeitmesseinrichtung 5 die hierfür benötigte Zeit T1 gemessen wird. Anschließend erfolgt die Entladung des Kondensators C über den Widerstand R2 durch Schließen des Schalters S21, wobei analog die Zeit T2 bestimmt wird. Abschließend wird der Kondensator C über die Parallelschaltung von R1 und R2 durch Schließen der Schalter S11 und S21 entladen und die Zeit T3 gemessen.

Eine Kompensationsmessung der Innenwiderstände, wie oben beschrieben, ist hier nicht notwendig. Es ist auch unerheblich, ob über einen oder zwei Schalter entladen wird. Entscheidend ist, von allen drei gemessenen Zeiten T1, T2, T3 die Verzögerungszeit Ts des Schmitt-Triggers 3 enthalten ist. Demnach setzen sich die gemessenen Zeiten wie folgt zusammen:

$$T1 = T1mess + TS, \qquad (5)$$

$$T2 = T2mess + TS, \tag{6}$$

$$T3 = T3mess + TS. \tag{7}$$

Dabei steht Timess (i=1,2,3) für die unverfälschte, zu bestimmende Entladezeit.

Weiterhin kommt hinzu, dass sich T3mess aufgrund der Parallelschaltung von R1 und R2 aus T1mess und T2mess berechnen lässt:

$$T3mess = (T1mess * T2mess)/(T1mess + T2mess). \tag{8}$$

Auflösen der Gleichungen 5 und 6 nach T1mess bzw. T2mess und Einsetzen in Gleichung 8 ergibt eine neue Gleichung, die sich in Gleichung 7 einsetzen lässt, woraus eine Beziehung zwischen T3 und Ts resultiert, die neben Ts nur von den gemessenen Größen T1, T2 und T3 abhängt. Vernachlässigen der quadratischen Glieder in Ts und Ausnutzen der Beziehung

$$(T1 + T2)/T3 = \frac{(T1 + T2)^2}{T1 \cdot T2} \approx 4 \tag{9}$$

für ähnliche Wert für T1 und T2, d.h. ähnliche Entladewiderstände ergibt sich damit näherungsweise:

$$Ts \approx 2 * (T3 - T1 * T2)/(T1 + T2)) \tag{10}$$

Der Fehler gegenüber der ebenfalls aus den Gleichungen 5 bis 8 ableitbaren exakten Formel liegt bei den für DMS üblichen Verhältnissen bei unter 0,1%.

Die Verzögerungszeit Ts wird in einem separaten Lauf vor jeder Messung ermittelt. Anschließend werden alle für die Berechnung der Widerstände nach Gleichung 3 oder 4 benötigten Zeiten um den bemittelten Betrag Ts reduziert. Für die erfindungsgemäße Widerstandsbestimmung nach Gleichung 3 oder 4 werden ausschließlich diese korrigierten Zeiten verwendet.

**Bezugszeichenliste**

1    Stromquelle
3    Schwellwertschalter
4    Signalverarbeitungsmittel
5    Zeitmesseinrichtung

C    Kondensator

R1    Referenzwiderstand
R2    Messwiderstand
R3    Widerstand

S11, S21    Schalter zu R1
S12, S22    Schalter zu R2
S31, S31    Schalter zu R3

**Patentansprüche**

1.  Verfahren zur Widerstandsmessung, wobei ein Kondensator, dessen Kapazität bekannt ist, wiederholt ge- und und entladen wird und die Lade- oder Entladezeit (til, ti2, ti; i=1,2,3) über mindestens zwei verschiedene Widerstände (R1, R2, R3) sowie über mindestens einen mit dem jeweiligen Widerstand in Reihe geschalteten ersten Schalter (S11, S21 bzw. S31), über mindestens einen mit dem jeweiligen Widerstand (R1, R2 bzw. R3) in Reihe geschalteten zweiten Schalter (S12, S22 bzw. S32) und über mit dem jeweiligen Widerstand (R1, R2 bzw. R3) in Reihe nebeneinander parallel geschalteten Schaltern (S11, S12, S21, S22 bzw. S31, S32) unter Verwendung eines Schwellwertschalters gemessen wird.

2. Verfahren zur Widerstandsmessung, wobei ein Kondensator wiederholt ge- und entladen wird und die Lade- oder Entladezeit (ti1, ti2, ti; i=1,2,3) über jeweils einen von mindestens zwei verschiedenen Widerständen (R1, R2, R3) sowie über mindestens einen mit dem jeweiligen Widerstand in Reihe geschalteten ersten Schalter (S11, S21 bzw. S31), über mindestens einen mit dem jeweiligen Widerstand (R1, R2 bzw. R3) in Reihe geschalteten zweiten Schalter (S12, S22 bzw. S32) und über mit dem jeweiligen Widerstand (R1, R2 bzw. R3) in Reihe nebeneinander parallel geschalteten Schaltern (S11, S12, S21, S22 bzw. S31, S32) unter Verwendung eines Schwellwertschalters gemessen wird und wobei weiterhin zur Bestimmung des Widerstandsverhältnisses von jeweils zwei Widerständen die Ergebnisse durcheinander dividiert werden.

3. Verfahren nach Anspruch 1 oder 2, **dadurch gekennzeichnet, dass** zur Entladung des Kondensators (C) jeweils mehrere parallel geschaltete erste Schalter (S11, S12 bzw. S21, S22 bzw. S31, S32) gruppenweise durchgeschaltet werden.

4. Verfahren nach einem der Ansprüche 1 bis 3, **dadurch gekennzeichnet, dass** die Bestimmung des Widerstands Ri (i=1,2,3) mittels der Beziehung

$$C \cdot Ri = ti - \sqrt{ti^2 + ti1 \cdot ti2 - ti1 \cdot ti - ti2 \cdot ti}$$

$$= M + K$$

erfolgt, die einen Messterm M und einen Korrekturterm K enthält.

5. Verfahren nach Anspruch 4, **dadurch gekennzeichnet, dass** der Korrekturterm und der Messterm mit unterschiedlichen Mittelungsarten gemittelt werden.

6. Verfahren nach Anspruch 5, **dadurch gekennzeichnet, dass** der Korrekturterm um einen bestimmten Faktor, insbesondere um einen Faktor zwischen 32 und 64, höher gemittelt wird als der Messterm.

7. Verfahren nach einem der Ansprüche 1 bis 6, **dadurch gekennzeichnet, dass** die gemessenen Zeiten ti, ti1, ti2 um eine Verzögerungszeit (Ts) des Schwellwertschalters reduziert werden.

8. Verfahren nach Anspruch 7, **dadurch gekennzeichnet, dass** die Verzögerungszeit durch Messen einer Zeit (T1, T2, T3) jeweils einer Kondensatoraufladung oder einer Kondensatorentladung über einen ersten Widerstand (R1) und einen zweiten Widerstand (R2) sowie eine Parallelschaltung dieser beiden Widerstände durch Schließen eines ersten Schalters (S11), eines zweiten Schalters (S21) bzw. dieser beiden Schalter (S11 und S21) bestimmt wird.

9. Verfahren nach Anspruch 8, **dadurch gekennzeichnet, dass** die Lade- bzw. Entladezeiten zur Widerstandsmessung und die Verzögerungszeit separat bestimmt werden.

10. Verfahren nach einem der Ansprüche 1 bis 9, **dadurch gekennzeichnet, dass** zur Zeitmessung ein Zeit-Digital-Wandler (TDC) verwendet wird.

11. Schaltungsanordnung zur Widerstandsmessung, insbesondere zur Ausführung des Verfahrens nach einem der Ansprüche 1 bis 10, mit Signalverarbeitungsmitteln (4) und einem Schwellwertschalter (3), mindestens einem Kondensator (C) und zu diesem zueinander parallel geschalteten mindestens zwei Widerständen (R1, R2, R3), wobei den Widerständen (R1, R2, R3) jeweils in Reihe ein erster Schalter (S11, S21 bzw. S31) zugeordnet ist, **dadurch gekennzeichnet, dass** dem ersten Schalter (S11, S21 bzw. S31) mindestens ein zweiter Schalter (S12, S22 bzw. S32) parallel geschaltet ist.

12. Schaltungsanordnung nach Anspruch 11, **dadurch gekennzeichnet, dass** mindestens einer der Widerstände ein bekannter Referenzwiderstand (R1) und mindestens ein Widerstand ein unbekannter Messwiderstand (R2, R3) ist.

**13.** Schaltungsanordnung nach Anspruch 11 oder 12, **dadurch gekennzeichnet, dass** zur Entladung des Kondensators (C) jeweils mehrere parallel geschaltete erste Schalter (S11, S12 bzw. S21, S22 bzw. S31, S32) gruppenweise durchschaltbar sind.

**14.** Schaltungsanordnung nach einem der Ansprüche 11 bis 13, **dadurch gekennzeichnet, dass** gleichzeitig schaltbare Gruppen von parallel geschalteten ersten und zweiten Schaltern (S11, S12 bzw. S21, S22 bzw. S31, S32) vorgesehen sind.

**15.** Schaltungsanordnung nach einem der Ansprüche 11 bis 14, **dadurch gekennzeichnet, dass** die Signalverarbeitungsmittel (4) eine elektronische Zeitmesseinrichtung (5) beinhalten.

**16.** Schaltungsanordnung nach Anspruch 15, **dadurch gekennzeichnet, dass** die Zeitmesseinrichtung (5) als Zeit-Digital-Wandler (TDC) ausgebildet ist.

**17.** Schaltungsanordnung nach einem der Ansprüche 11 bis 16, **dadurch gekennzeichnet, dass** die Signalverarbeitungsmittel (4) zur Mittelung von Messwerten mit einer Mehrzahl unterschiedlicher Mittelungsraten ausgebildet sind.

**Claims**

**1.** Method for measuring the resistance, wherein a capacitor (C), whose capacitance is known, is repeatedly charged and discharged and the charging or discharging time (ti1, ti2, ti; i=2,2,3) is measured by means of at least two resistors (R1, R2, R3), as well as by means of at least one first switch (S11, S21 or S31) connected in series with a respective resistor, by means of at least one second switch (S12, S22 or S32) connected in series with a respective resistor (R1, R2 or R3) and by means of juxtaposed, parallel switches (S11, S12, S21, S22 or S31, S32) connected in series with the resistors (R1, R2 or R3), whilst using a threshold switch.

**2.** Method for measuring the resistance, wherein a capacitor (C), is repeatedly charged and discharged and the charging or discharging time (ti1, ti2, ti; i=2,2,3) is measured by means of one of at least two resistors (R1, R2, R3), as well as by means of at least one first switch (S11, S21 or S31) connected in series with the respective resistor, by means of a least one second switch (S12, S22 or S32) connected in series with the respective resistor (R1, R2 or R3) and by means of juxtaposed, parallel switches (S11, S12, S21, S22 or S31, S32) connected in series with the resistor (R1, R2 or R3), whilst using a threshold switch and wherein furtheron the results are divided for determination of the resistance ratios of two resistors in each case.

**3.** Method according to claim 1 or 2, **characterized in that** in each case several parallel-connected, first switches (S11, S12 or S21, S22 or S31, S32) are switched through groupwise for discharging the capacitor (C).

**4.** Method according to one of the claims 1 to 3, **characterized in that** the determination of the resistance Ri (i=1,2,3) takes place by means of the relationship

$$C \cdot Ri = ti \cdot \sqrt{ti^2 + ti1 \cdot ti2 - ti1 \cdot ti - ti2 \cdot ti}$$

$$= M + K$$

which contains a measurement term M and a correction term K.

**5.** Method according to claim 4, **characterized in that** the correction term and measurement term are averaged with different averaging methods.

**6.** Method according to claim 5, **characterized in that** the correction term is averaged higher than the measurement term by a specific factor, particularly by a factor between 32 and 64.

**7.** Method according to one of the claims 1 to 6, **characterized in that** the measured times ti, ti1, ti2 are reduced by a delay time (Ts) of the threshold switch.

8.   Method according to claim 7, **characterized in that** the delay time is determined by measuring a time (T1, T2, T3) of in each case a capacitor charging or a capacitor discharging operation by means of a first resistor (R1) and a second resistor (R2), as well as a parallel connection of these two resistors by closing a first switch (S11), a second switch (S21) or both of these switches (S11 and S21).

9.   Method according to claim 8, **characterized in that** the charging and discharging times for resistance measurement and the delay time are determined separately.

10.  Method according to one of the claims 1 to 9, **characterized in that** a time-digital converter is used for time measurement purposes.

11.  Circuit arrangement for resistance measurement,
     particularly for performing the method according to one of the claims 1 to 10, with signal processing means (4) and a threshold switch (3), at least one capacitor (C) and at least two resistors (R1, R2, R3) connected in parallel with respect thereto, a first switch (S11, S21 or S31) in each case being connected in series with the resistors (R1, R2, R3), **characterized in that** at least one second switch (S12, S22 or S32) is connected in parallel to the first switch (S11, S21 or S31).

12.  Circuit arrangement according to claim 11, **characterized in that** at least one of the resistors is a known reference resistor (R1) and at least one resistor is an unknown precision resistor (R2, R3).

13.  Circuit arrangement according to claim 11 or 12, **characterized in that** for discharging the capacitor (C) in each case several, parallel-connected first switches (S11, S12 or S21, S22 or S31, S32) can be switched through groupwise.

14.  Circuit arrangement according to one of the claims 11 to 13, **characterized in that** there are simultaneously switchable groups of parallel-connected, first and second switches (S11, S12 or S21, S22 or S31, S32).

15.  Circuit arrangement according to one of the claims 11 to 14, **characterized in that** the signal processing means (4) incorporates an electronic time measuring device (5).

16.  Circuit arrangement according to claim 15, **characterized in that** the time measuring device (5) is constructed as a time-digital converter (TDC).

17.  Circuit arrangement according to one of the claims 11 to 16, **characterized in that** the signal processing means (4) for averaging measured values are constructed with a plurality of different averaging rates.

**Revendications**

1.   Procédé de mesure de résistance, selon lequel on charge et on décharge de manière répétée un condensateur dont la capacité est connue, et dans lequel on mesure le temps de charge ou de décharge (ti1, ti2, ti; i=1,2,3) au moyen d'au moins deux résistances différentes (R1, R2, R3) ainsi qu'au moyen d'au moins un premier commutateur (S11, S21 ou S31) monté en série avec la résistance respective, au moyen d'au moins un deuxième commutateur (S12, S22 ou S32) monté en série avec la résistance respective (R1, R2 ou R3) et au moyen de commutateurs (S11, S12, S21, S22 ou S31, S32) montés en série et en parallèle par groupes les uns à côté des autres en utilisant un commutateur de valeur seuil.

2.   Procédé de mesure de résistance, selon lequel on charge et on décharge de manière répétée un condensateur et selon lequel on mesure le temps de charge ou de décharge (ti1, ti2, ti; i=1,2,3) au moyen respectivement d'une parmi au moins deux résistances différentes (R1, R2, R3) ainsi qu'au moyen d'au moins un premier commutateur (S11, S21 ou S31) monté en série avec la résistance respective, au moyen d'au moins un deuxième commutateur (S12, S22 ou S32) monté en série avec la résistance respective (R1, R2 ou R3) et au moyen de commutateurs (S11, S12, S21, S22 ou S31, S32) montés en série et en parallèle par groupes les uns à côté des autres avec la résistance respective (R1, R2 ou R3), en utilisant un commutateur de valeur seuil, et selon lequel on divise ensuite les résultats entre eux pour déterminer le rapport de résistance de deux résistances respectives.

3.   Procédé selon la revendication 1 ou 2, **caractérisé en ce que** pour décharger le condensateur ( C ), on connecte par groupes respectivement plusieurs premiers commutateurs montés en parallèle (S11, S12 ou S21, S22 ou S31, S32).

**4.** Procédé selon l'une quelconque des revendications 1 à 3, **caractérisé en ce que** la détermination de la résistance Ri (i=1,2,3) s'effectue au moyen de la relation suivante :

$$C{\cdot}Ri = \text{ti} - \sqrt{ti^2 + ti1{\cdot}ti2 - ti1{\cdot}ti - ti2{\cdot}ti}$$

$$= M + K$$

comprenant un terme de mesure M et un terme de correction K.

**5.** Procédé selon la revendication 4, **caractérisé en ce que** le terme de correction et le terme de mesure sont moyennés par des taux de moyennage différents.

**6.** Procédé selon la revendication 5, **caractérisé en ce que** le terme de correction est moyenné plus haut que le terme de mesure d'un facteur déterminé, en particulier d'un facteur compris entre 32 et 64.

**7.** Procédé selon l'une quelconque des revendications 1 à 6, **caractérisé en ce que** les temps mesurés ti, ti1, ti2 sont réduits d'un temps de retard (Ts) du commutateur de valeur de seuil.

**8.** Procédé selon la revendication 7, **caractérisé en ce que** le temps de retard est déterminé par la mesure d'un temps (T1, T2, T3) respectivement d'une charge de condensateur ou d'une décharge de condensateur au moyen d'une première résistance (R1) et d'une deuxième résistance (R2) ainsi que d'un montage en parallèle de ces deux résistances par fermeture d'un premier commutateur (S11), d'un deuxième commutateur (S21) ou'de ces deux commutateurs (S11 et S21).

**9.** Procédé selon la revendication 8, **caractérisé en ce que** les durées de charge et de décharge pour la mesure de la résistance et la durée de retard sont déterminées séparément.

**10.** Procédé selon l'une quelconque des revendications 1 à 9, **caractérisé en ce que** l'on utilise un convertisseur numérique temporel (TDC) pour la mesure de durées.

**11.** Circuit pour la mesure de la résistance, en particulier pour la mise en oeuvre du procédé selon l'une quelconque des revendications 1 à 10, comprenant des moyens de traitement de signaux (4) et un commutateur de valeur seuil (3), au moins un condensateur ( C ) et au moins deux résistances (R1, R2, R3) montées en parallèle par rapport au condensateur, dans lequel est associé aux résistances (R1, R2, R3) respectivement en série un premier commutateur (S11, S21 ou S31), **caractérisé en ce qu'**au moins un deuxième commutateur (S12, S22 ou S32) est monté en parallèle sur le premier commutateur (S11, S21 ou S31).

**12.** Circuit selon la revendication 11, **caractérisé en ce qu'**au moins une des résistances est une résistance de référence (R1) connue et **en ce qu'**au moins une résistance est une résistance de mesure (R2, R3) inconnue.

**13.** Circuit selon 1a revendication 11 ou 12, **caractérisé en ce que** pour décharger le condensateur ( C ) on peut connecter en groupes respectivement plusieurs premiers commutateurs (S11, S12 ou S21, S22 ou S31, S32) montés en parallèle.

**14.** Circuit selon l'une quelconque des revendications 11 à 13, **caractérisé en ce que** l'on prévoit des groupes de premiers et deuxièmes commutateurs (S11, S12 ou S21, S22 ou S31, S32) connectables simultanément.

**15.** Circuit selon l'une quelconque des revendications 11 à 14, **caractérisé en ce que** les moyens (4) de traitement de signaux comprennent un dispositif (5) électronique de mesure de durées.

**16.** Circuit selon la revendication 15, **caractérisé en ce que** le dispositif (5) électronique de mesure de durées se présente sous la forme d'un convertisseur numérique temporel (TDC).

**17.** Circuit selon l'une quelconque des revendications 11 à 16, **caractérisé en ce que** les moyens (4) de traitement des signaux comprennent une pluralité de taux de moyennage différents pour moyenner les valeurs de mesure.